# EUROPÄISCHE PATENTANMELDUNG

(11) **EP 4 783 223 A1**
(43) Veröffentlichungstag der Anmeldung: **29.07.2026**
(21) Anmeldenummer: 25154162.9
(22) Anmeldetag: 27.01.2025
(51) Int. Cl.: H01J 37/317, H05H 7/12

(54) **VERFAHREN ZUR IONENIMPLANTATION IN EIN SUBSTRAT**

(71) Anmelder: mi2-factory GmbH, 07745 Jena (DE)
(72) Erfinder: CSATO, Constantin, 07745 Jena (DE); KRIPPENDORF, Florian, 07745 Jena (DE)
(74) Vertreter: Wächter, Jochen

(57) **Zusammenfassung**

Das Verfahren zur Ionenimplantation in ein Substrat (12) umfasst das Implantieren von Dotieratomen in das Substrat (12) und/oder Erzeugen von Defektstellen im Substrat (12) mittels Ionenimplantation unter Verwendung eines Energiefilters (20), wobei ein von einer lonenstrahlerzeugungsvorrichtung (11) erzeugter Ionenstrahl (10) zunächst durch den Energiefilter (20) hindurchtritt und anschließend in das Substrat (12) gelangt. Der Energiefilter (20) ist eine mikrostrukturierte Membran mit einem vordefinierten Strukturprofil zur Einstellung eines durch die Implantation hervorgerufenen Dotierstofftiefenprofils und/oder Defekttiefenprofils im Substrat (12). In einer Vielzahl von quer zur Strahlrichtung voneinander beabstandeten Bereichen (48) des Energiefilters (20), in denen der Energiefilter (20) einschließlich einer der Mikrostrukturen (50) in Strahlrichtung jeweils eine Ausdehnung (w) aufweist, die oberhalb einer vorbestimmten Grenze liegt, wird eine partielle Implantation von Fremdatomen mittels des lonenstrahls (10) durchgeführt und somit eine Vielzahl von voneinander beabstandeten, mit den Fremdatomen implantierten Implantationsbereichen (52) im Energiefilter (20) gebildet.

## Beschreibung

Die Erfindung betrifft ein Verfahren zur Ionenimplantation in ein Substrat.

Mittels Ionenimplantation kann eine Dotierung bzw. die Erzeugung von Defektprofilen in Substraten aus verschiedenen Materialien, wie etwa Halbleitern (z.B. Silizium, Siliziumcarbid, Galliumnitrid) oder auch optischen Materialien (z.B. LiNbO3), mit vordefinierten Tiefenprofilen im Tiefenbereich bis hin zu einigen 100 Mikrometern erreicht werden.

Wünschenswert ist es dabei insbesondere, Tiefenprofile zu erzeugen, die durch eine größere Tiefenverteilungsbreite charakterisiert sind als die Breite eines durch einen monoenergetischen lonenstrahlung erzeugbaren Dotierkonzentrationspeaks oder Defektkonzentrationspeaks. Oft ist es auch gewünscht, Dotier- oder Defekttiefenprofile zu erzeugen, welche durch eine oder einige wenige einfache monoenergetische Implantationen nicht erzeugt werden können.

Zu diesen Zwecken werden Energiefilter eingesetzt, die als mikrostrukturierte Membran ausgebildet sind und durch die der lonenstrahl vor dem Auftreffen auf das Substrat hindurchtritt.

In Fällen, in denen das Dotierprofil unmittelbar an der Oberfläche des Substrats beginnen soll, treten dabei bisweilen Probleme aufgrund von produktionsbedingten Abweichungen der Mikrostrukturen des Energiefilters auf.

Es ist somit eine Aufgabe der Erfindung, ein Verfahren zu schaffen, mit dem unmittelbar an der Oberfläche des Substrats beginnende Dotierprofile mit hoher Verlässlichkeit erzeugt werden können.

Diese Aufgabe wird durch die Merkmale des Anspruchs 1 gelöst.

Erfindungsgemäß umfasst das Verfahren zur Ionenimplantation in ein Substrat das Implantieren von Dotieratomen in das Substrat und/oder Erzeugen von Defektstellen im Substrat mittels Ionenimplantation unter Verwendung eines Energiefilters, wobei ein von einer lonenstrahlerzeugungsvorrichtung erzeugter lonenstrahl zunächst durch den Energiefilter hindurchtritt und anschließend in das Substrat gelangt. Der Energiefilter ist eine mikrostrukturierte Membran mit einem vordefinierten Strukturprofil zur Einstellung eines durch die Implantation hervorgerufenen Dotierstofftiefenprofils und/oder Defekttiefenprofils im Substrat. In einer Vielzahl von quer zur Strahlrichtung voneinander beabstandeten Bereichen des Energiefilters, in denen der Energiefilter einschließlich einer der Mikrostrukturen in Strahlrichtung jeweils eine Ausdehnung oder Dicke aufweist, die oberhalb einer vorbestimmten Grenze liegt, wird eine partielle Implantation von Fremdatomen (Dotieratomen) mittels des lonenstrahls durchgeführt und somit eine Vielzahl von voneinander beabstandeten, mit den Fremdatomen implantierten (bzw. dotierten) Implantationsbereichen im Energiefilter gebildet.

Damit ist es möglich, äußerst genau und zuverlässig Dotierprofile oder Defektprofile im Substrat zu erzeugen, die an der dem lonenstrahl zugewandten Oberfläche des Substrats beginnen. Insbesondere sind Fertigungstoleranzen der Mikrostrukturen weniger problematisch und die Form der Mikrostrukturen muss im Bereich der Spitzen nicht einer idealen geometrischen Form entsprechen.

Um die partielle Implantation in den Energiefilter sicherzustellen, ist eine Berechnung anhand der Dicke des Energiefilters einschließlich seiner Mikrostrukturen, der Form und Anordnung der Mikrostrukturen, der Primärenergie des lonenstrahls und des Bremsverhaltens der lonensorte im Material des Energiefilters notwendig. Idealerweise wird die vorbestimmte Grenze dann so gewählt, dass in den Dickenbereichen des Energiefilters, in denen die Bereiche um die Spitzen der Mikrostrukturen liegen, der entsprechende Teilbereich des lonenstrahls vollständig im Energiefilter absorbiert wird. In den übrigen Dickenbereichen des Energiefilters erfolgt hingegen eine Transmission der anderen Teilbereiche des lonenstrahls.

Vorzugsweise sind die Implantationsbereiche im Energiefilter periodisch angeordnet. Auf diese Weise gelingt es, ein über die Breite homogenes Dotierprofil im Substrat zu schaffen. Besonders bevorzugt sind die Abstände zwischen den Implantationsbereichen in einer bestimmten Richtung jeweils identisch. Dies wird ermöglicht durch eine gleichmäßige Verteilung von identischen Mikrostrukturen im Energiefilter.

Die Dicke der Implantationsbereiche im Energiefilter in Strahlrichtung beträgt vorzugsweise mindestens 0,1 µm, mehr bevorzugt mindestens 0,2 µm, besonders bevorzugt mindestens 0,4 µm.

Die Dicke der Implantationsbereiche im Energiefilter in Strahlrichtung beträgt vorzugsweise zwischen 0,1 µm und 2,0 µm, mehr bevorzugt zwischen 0,15 µm und 1,5 µm, besonders bevorzugt zwischen 0,25 µm und 1,2 µm.

Bei einem lonenstrahl mit Ionen aus Stickstoff oder Aluminium, einer Primärenergie von 20 MeV und einem Energiefilter aus Silizium liegt das longitudinale Straggling und somit die Dicke der Implantationsbereiche im Energiefilter in Strahlrichtung im Bereich von 0,5 µm.

Bei 2 MeV Protonen hingegen liegt das longitudinale Straggling und somit die Dicke der Implantationsbereiche im Energiefilter in Strahlrichtung im Bereich von 1,0 µm.

Die Primärenergie des monoenergetischen lonenstrahls beträgt vorzugsweise zwischen 1 MeV und 60 MeV, mehr bevorzugt zwischen 2 MeV und 50 MeV, besonders bevorzugt zwischen 5 MeV und 40 MeV.

So liegt üblicherweise die Energie bei lonenstrahlen aus N oder AI z.B. im Bereich zwischen 10 und 30 MeV und bei H oder He unter 4 MeV.

Die Dicke des Energiefilters im Bereich maximaler Erstreckung, d.h. im Bereich einer Mikrostruktur, beträgt vorzugsweise zwischen 3 µm und 60 µm, mehr bevorzugt zwischen 5 µm und 50 µm, besonders bevorzugt zwischen 7 µm und 20 µm.

Die Dicke der Dotierschicht im Substrat beträgt vorzugsweise zwischen 0,5 µm und 50 µm, mehr bevorzugt zwischen 2 µm und 25 µm, besonders bevorzugt zwischen 3 µm und 20 µm.

In einer Ausführungsform sind die Mikrostrukturen des Energiefilters bevorzugt zum Substrat gewandte, abragende Mikrostrukturen, und die Implantationsbereiche liegen in den abragenden Mikrostrukturen.

In diesem Fall ist es bevorzugt, dass sich die Implantationsbereiche geradlinig erstrecken.

In einer alternativen Ausführungsform sind die Mikrostrukturen des Energiefilters vom Substrat abgewandte, abragende Mikrostrukturen, und die Implantationsbereiche verlaufen abschnittsweise von einer geraden Fläche des Energiefilters aus und verlaufen abschnittsweise von der geraden Fläche des Energiefilters entfernt, also im Inneren des Energiefilters.

In diesem Fall bilden die Implantationsbereiche vorzugsweise dreidimensionale Strukturen mit Ausdehnung in Dickenrichtung des Energiefilters.

Die dreidimensionalen Strukturen entsprechen dabei bevorzugt den Umrissen der abragenden Mikrostrukturen.

Allgemein im Rahmen der Erfindung sind die abragenden Mikrostrukturen als Vorsprünge ausgebildet.

In bevorzugten Ausführungsformen der Erfindung können die abragenden Mikrostrukturen abgeflachte Spitzen aufweisen. Dadurch wird die Herstellung des Energiefilters vereinfacht.

Allgemein weisen die abragenden Mikrostrukturen bevorzugt eine Zackenform auf. Diese dient zur Homogenisierung des Dotierprofils im Substrat.

Die vorbestimmte Obergrenze der Ausdehnung oder Dicke, oberhalb der die partielle Implantation in den Energiefilter stattfindet, wird bevorzugt derart festgelegt, dass die Implantationsbereiche des Energiefilters in Dickenbereichen des Energiefilters, in denen die Spitzen der Mikrostrukturen liegen, beabstandet von den Spitzen der Mikrostrukturen (im Fall von zum Substrat gewandten Mikrostrukturen) oder beabstandet von der geraden Fläche des Energiefilters (im Fall von zum lonenstrahl hin gewandten Mikrostrukturen) sind, besonders bevorzugt in einem Abstand von mindestens 0,1 µm oder 0,2 µm. Der Abstand kann bevorzugt in einem Bereich zwischen 0,05 µm und 5 µm, mehr bevorzugt zwischen 0,1 µm und 3 µm, besonders bevorzugt zwischen 0,2 µm und 1,5 µm liegen.

Das Substrat kann allgemein aus unterschiedlichen Materialien, wie etwa Halbleitern (z.B. Silizium, Siliziumcarbid, Galliumnitrid) oder auch optischen Materialien (z.B. LiNbO3) gebildet sein. SiC vom Polytyp 4H, 6H oder 3C haben sich als vorteilhaft für die Produktion von Halbleiterbauelementen herausgestellt.

Das Dotieren erfolgt bevorzugt mit Ionen aus einem der folgenden Elemente: N, P, B oder Al. Weitere geeignete lonensorten sind H oder He. Der Energiefilter kann auch aus verschiedenen Schichten unterschiedlicher Materialien aufgebaut sein.

### Kurze Beschreibung der Zeichnungen

- Fig. 1: ist eine schematische Ansicht einer Bestrahlungsanordnung mit Energiefilter zur Ionenimplantation in ein Substrat.
- Fig. 2: ist eine schematische Darstellung der Wirkweise eines Energiefilters, der beim erfindungsgemäßen Verfahren Verwendung finden kann.
- Fig. 3: ist eine schematische Darstellung verschiedener Dotierprofile, die mittels verschieden strukturierter Energiefilter erzeugt werden können.
- Fig. 4: zeigt schematisch den Ablauf einer erfindungsgemäßen Ionenimplantation in eine an einer Oberfläche des Substrats beginnende Schicht sowie ein daraus resultierendes Dotierprofil des Substrats.
- Fig. 5a-c: zeigen verschiedene weitere Möglichkeiten von Dotierprofilen, die mit dem erfindungsgemäßen Verfahren erzeugt werden können.
- Fig. 6a, b: zeigen schematisch eine Ausführungsform des erfindungsgemäßen Verfahrens, bei dem die Implantationsbereiche des Energiefilters in den abragenden Mikrostrukturen liegen, die dem Substrat zugewandt sind, sowie ein entsprechendes Dotierprofil des Substrats.
- Fig. 7a, b: zeigt schematisch eine alternative Ausführungsform des erfindungsgemäßen Verfahrens, bei dem die Implantationsbereiche des Energiefilters wiederum in den abragenden Mikrostrukturen liegen, die dem Substrat zugewandt sind; sowie ein entsprechendes Dotierprofil des Substrats.
- Fig. 8a, b: zeigt schematisch eine Ausführungsform des erfindungsgemäßen Verfahrens, bei dem die Implantationsbereiche des Energiefilters den abragenden Mikrostrukturen, die dem Substrat abgewandt sind, gegenüberliegen, sowie ein entsprechendes Dotierprofil des Substrats.
- Fig. 9a, b: zeigt schematisch eine Ausführungsform des erfindungsgemäßen Verfahrens, bei dem wiederum die Implantationsbereiche des Energiefilters den abragenden Mikrostrukturen, die dem Substrat abgewandt sind, gegenüberliegen, sowie ein entsprechendes Dotierprofil des Substrats.

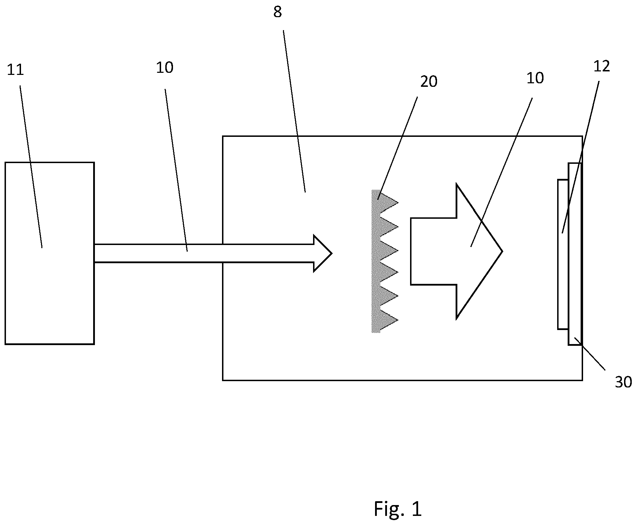

Fig. 1 zeigt eine Bestrahlungskammer 8, in der üblicherweise ein Hochvakuum vorliegt. In der Bestrahlungskammer 8 ist das zu dotierende Substrat 12 in einer Substrathalterung 30 aufgenommen.

Ein lonenstrahl 10 wird mittels einer lonenstrahlerzeugungsvorrichtung 11, die üblicherweise als Teilchenbeschleuniger ausgebildet ist, erzeugt und in die Bestrahlungskammer 8 geleitet. Dort wird die Energie des lonenstrahls 10 durch einen Energiefilter 20 aufgespreizt und er trifft auf das zu bestrahlende Substrat 12. Alternativ kann der Energiefilter 20 in einer separaten, mit Ventilen verschließbaren Vakuumkammer innerhalb der Bestrahlungskammer 8 oder unmittelbar angrenzend an die Bestrahlungskammer 8 angeordnet sein.

Die Substrathalterung 30 muss nicht stationär sein, sondern kann optional mit einer Einrichtung zum Verschieben des Substrats 12 in x-y (in der Ebene senkrecht zur Blattebene) versehen sein. Als Substrathalterung 30 kommt außerdem auch ein Waferrad in Betracht, auf welchem die zu implantierenden Substrate 12 fixiert werden und das sich während der Implantation dreht. Auch eine Verschiebung der Substrathalterung 30 in Strahlrichtung (z-Richtung) kann möglich sein. Weiterhin kann die Substrathalterung 30 optional mit einer Heizung oder Kühlung versehen sein.

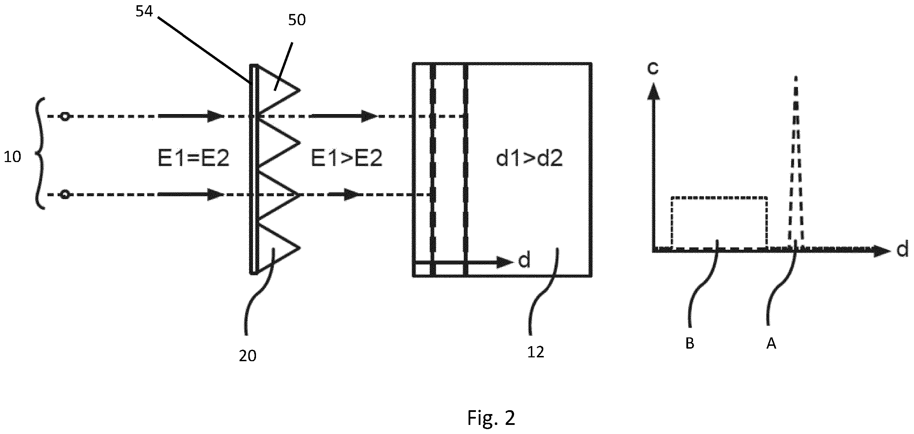

Das Grundprinzip des Energiefilters 20 ist in Fig. 2 dargestellt. Der monoenergetische lonenstrahl 10 wird beim Durchtritt durch den als mikrostrukturierte Membran ausgestalteten Energiefilter 20 abhängig vom Eintrittsort in seiner Energie modifiziert. Die resultierende Energieverteilung der Ionen des lonenstrahls 10 führt zu einer Modifikation des Tiefenprofils des implantierten Stoffes in der Matrix des Substrats 12. E1 bezeichnet die Energie eines ersten Ions, E2 bezeichnet die Energie eines zweiten Ions, c bezeichnet die Dotierkonzentration und d bezeichnet die Tiefe im Substrat 12. Im Diagramm rechts ist die übliche Gaußverteilung mit Bezugszeichen A gekennzeichnet, die ohne Einsatz eines Energiefilters 20 entsteht. Hingegen ist beispielhaft mit Bezugszeichen B eine Rechteckverteilung skizziert, die bei Einsatz eines Energiefilters 20 erzielt werden kann.

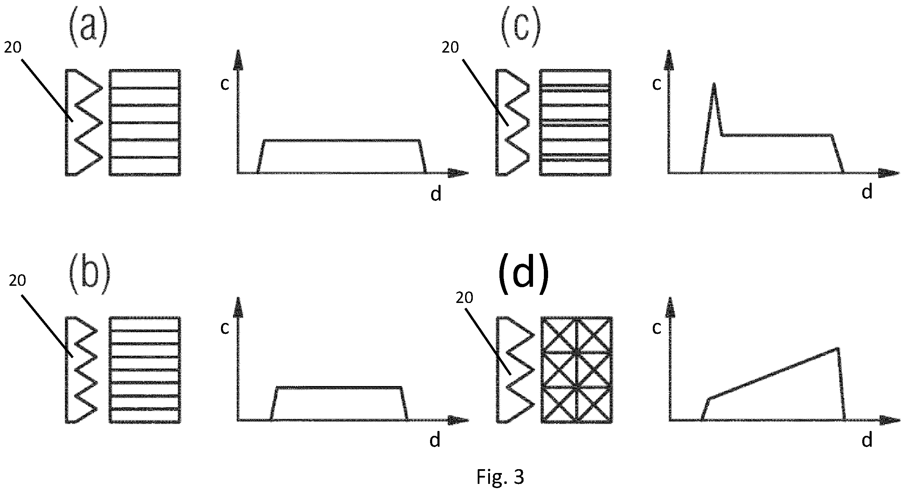

Die in Fig. 3 gezeigten Layouts bzw. dreidimensionalen Strukturen von Energiefiltern 20 zeigen die prinzipiellen Möglichkeiten, mittels Energiefilter 20 eine Vielzahl von Dotierstofftiefenprofilen oder Defekttiefenprofilen zu erzeugen, c bezeichnet wiederum die Dotierkonzentration und d bezeichnet wiederum die Tiefe im Substrat 12. Die Filterstrukturprofile können im Prinzip miteinander kombiniert werden, um neue Filterstrukturprofile und somit neue Dotierstofftiefenprofile oder Defekttiefenprofile zu erhalten. Diese in Fig, 3 gezeigten Strukturen des Energiefilters 20 sind auch im Rahmen der Erfindung anwendbar, ebenso viele weitere Strukturprofile.

Die Mikrostrukturen 50 in Fig. 3 (a) weisen die Form von streifenförmigen Rippen mit dreieckigem Querschnitt auf. Die Mikrostrukturen 50 in Fig. 3 (b) weisen ebenfalls die Form von streifenförmigen Rippen mit dreieckigem Querschnitt auf, allerdings mit kleineren Abmessungen der Vorsprünge. Die Mikrostrukturen 50 in Fig. 3 (c) weisen die Form von streifenförmigen Rippen mit im Wesentlichen dreieckigem Querschnitt, aber mit abgeflachten Spitzen auf. Die Mikrostrukturen 50 in Fig. 3 (d) weisen eine Pyramidenform auf. Die Pyramidenform kann auch abgeflachte Spitzen aufweisen. Neben den beschriebenen Formen existieren noch viele weitere geeignete Formen.

Der Energiefilter 20 ist in der Regel aus Silizium hergestellt, bevorzugt aus kristallinem, polykristallinem oder amorphem Silizium. Alternativ kann er aus SiC hergestellt sein, bevorzugt aus kristallinem, polykristallinem oder amorphem SiC. Weitere Möglichkeiten des Materials sind keramische Werkstoffe. Außerdem kommen Schichtsysteme mit verschiedenen Schichten aus den genannten Materialien in Betracht.

Der Energiefilter 20 besitzt eine Dicke von zwischen 3 µm und 60 µm, vorzugsweise zwischen 5 µm und 50 µm und besonders bevorzugt zwischen 7 µm und 20 µm. Er kann in einem Filterrahmen (nicht dargestellt) gehalten sein. Der Filterrahmen kann austauschbar in einer Filterhalterung (nicht dargestellt) aufgenommen sein.

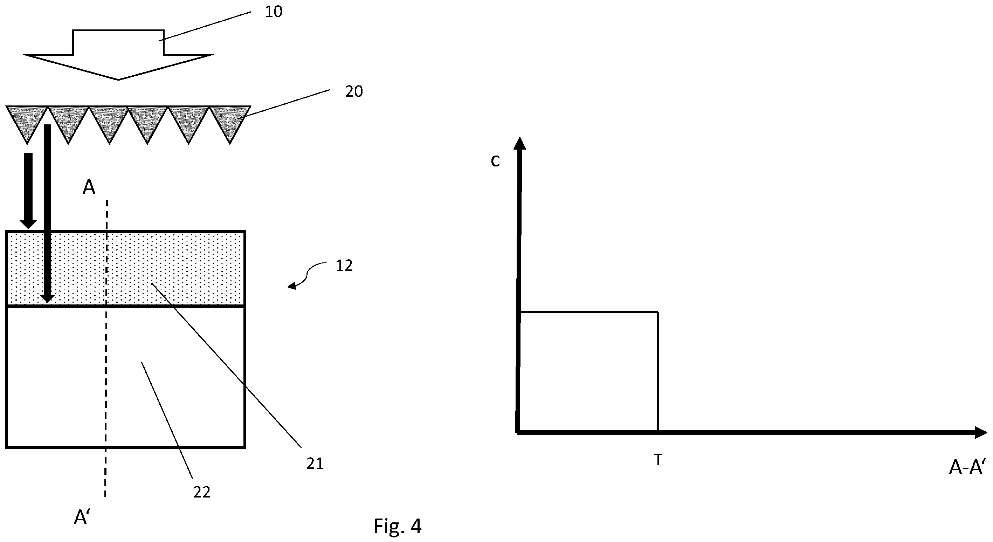

Bei der in Fig. 4 dargestellten Dotierung einer Schicht 21, die an der Oberfläche des Substrats beginnt, erfolgt die lonenimplantation in das Substrat 12 von einer Vorderseite des Substrats 12. Der kurze, schwarz gefüllte Pfeil deutet die durch den Energiefilter 20 transmittierten Ionen minimaler Energie an, und der lange, schwarz gefüllte Pfeil deutet die durch den Energiefilter 20 transmittierten Ionen maximaler Energie an. Das resultierende Dotierprofil entlang des Schnitts A-A' ist rechts im Koordinatensystem gezeigt. c steht wieder für die Dotierkonzentration. Das Dotierprofil ist über die gesamte Schicht 21 hinweg annähernd gleichmäßig. Die Schicht 21 erstreckt sich von der dem lonenstrahl 10 zugewandten Oberfläche des Substrats 12 aus bis zu einer vorbestimmten Dotiertiefe T, wo sich ein restlicher Teil 22 des Substrats 12 anschließen kann, der nicht von der Ionenimplantation mittels Energiefilter 20 betroffen ist. Es ist aber auch denkbar, dass das gesamte Substrat 12 mittels der lonenimplantation dotiert wird. Durch den Einsatz von Masken ist es auch möglich, lediglich Teilbereiche des Substrats 12 zu dotieren.

Für die Ausbildung einer n-dotierten Schicht 21 ist die Implantation mit Ionen aus Stickstoff oder Phosphor besonders geeignet, während für eine p-dotierte Schicht die Implantation mit Ionen aus Bor oder Aluminium besonders geeignet ist.

Die Dicke der Schicht 21 liegt vorzugsweise zwischen 0,5 und 50 µm, mehr bevorzugt zwischen 3 und 20 µm.

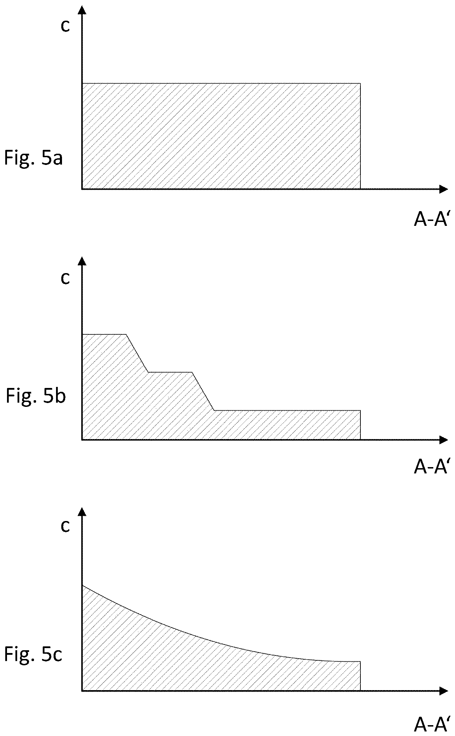

Fig. 5a bis 5c zeigen mögliche weitere bevorzugte Dotierprofile im Substrat 12. Mit dem erfindungsgemäßen Verfahren können beliebige Profilformen des Dotierprofils erzeugt werden, solange das Profil unmittelbar an der dem lonenstrahl 10 zugewandten Oberfläche des Substrats 12 mit einem von Null verschiedenen Wert beginnt.

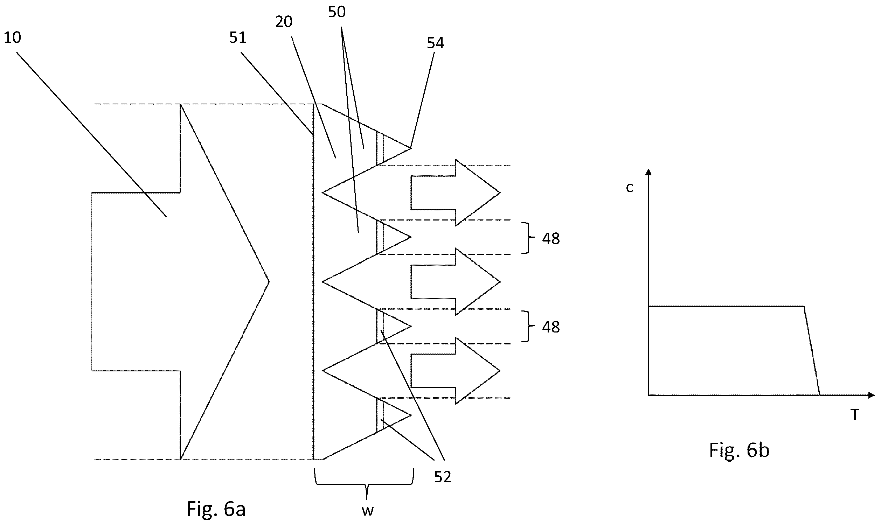

In Fig. 6a ist schematisch eine Ausführungsform des erfindungsgemäßen Verfahrens dargestellt, bei dem die abragenden Mikrostrukturen 50 des Energiefilters 20 dem Substrat 12 zugewandt sind. Die gerade Fläche 51 des Energiefilters 20, die den Mikrostrukturen 50 gegenüberliegt, ist entsprechend dem lonenstrahl 10 zugewandt.

In diesem Fall sind die Implantationsbereiche 52 als senkrecht zur Strahlrichtung verlaufende Streifen in den Mikrostrukturen 50 ausgebildet, die in quer zur Strahlrichtung voneinander beabstandeten Bereichen 48 der größten Dicke des Energiefilters 20 liegen. In diesen Bereichen 48 ist die Ausdehnung w des Energiefilters 20 einschließlich einer der Mikrostrukturen 50 in Strahlrichtung jeweils oberhalb einer vorbestimmten Grenze, sodass die Fremdatome des lonenstrahls 10 in diesen Bereichen 48 nicht aus dem Energiefilter 20 austreten, sondern in den Energiefilter 20 implantiert werden.

Die kleinen Pfeile zeigen die Bereiche des partiell transmittierten lonenstrahls 10 an, die - quer zur Strahlrichtung betrachtet - zwischen den Bereichen 48 und somit auch zwischen den Implantationsbereichen 52 liegen. Das resultierende Dotierprofil im Substrat 12 ist in Fig. 6b dargestellt.

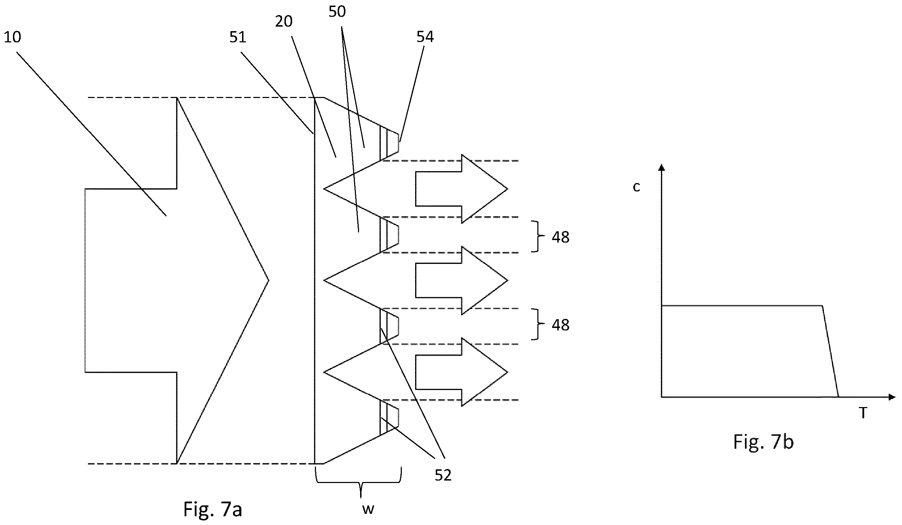

Die in Fig. 7a dargestellte Ausführungsform entspricht der Ausführungsform aus Fig. 6a mit dem Unterschied, dass die Mikrostrukturen 50 abgeflachte Spitzen 54 aufweisen. Wie im Dotierprofil des Substrats in Fig. 7b zu erkennen ist, besteht kein Unterschied zum Dotierprofil des Substrats gemäß Fig. 6b.

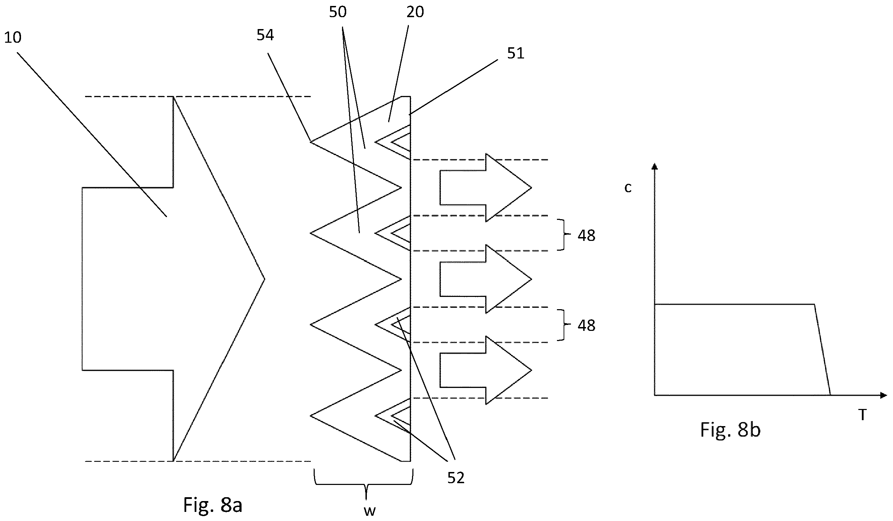

In Fig. 8a ist schematisch eine alternative Ausführungsform des erfindungsgemäßen Verfahrens dargestellt, bei dem die abragenden Mikrostrukturen 50 des Energiefilters 20 dem Substrat 12 abgewandt und dem lonenstrahl 10 zugewandt sind. Die gerade Fläche 51 des Energiefilters 20, die den Mikrostrukturen 50 gegenüberliegt, ist entsprechend dem Substrat 12 zugewandt.

In diesem Fall sind die Implantationsbereiche 52 in einem Bereich des Energiefilters 20 angeordnet, der an die gerade Fläche 51 des Energiefilters 20 angrenzt. Die Implantationsbereiche 52 zeigen hier einen Verlauf, welcher dem Umriss des Endbereichs um die Spitze 54 der jeweils gegenüberliegenden Mikrostruktur 50 entspricht. Im dargestellten Beispielsfall ist dies eine perfekte Zackenform mit dreieckigem Querschnitt. In jedem einzelnen Teilabschnitt sind die Implantationsbereiche 52 jeweils wieder in Streifenform ausgebildet. Das resultierende Dotierprofil im Substrat 12 ist in Fig. 8b dargestellt.

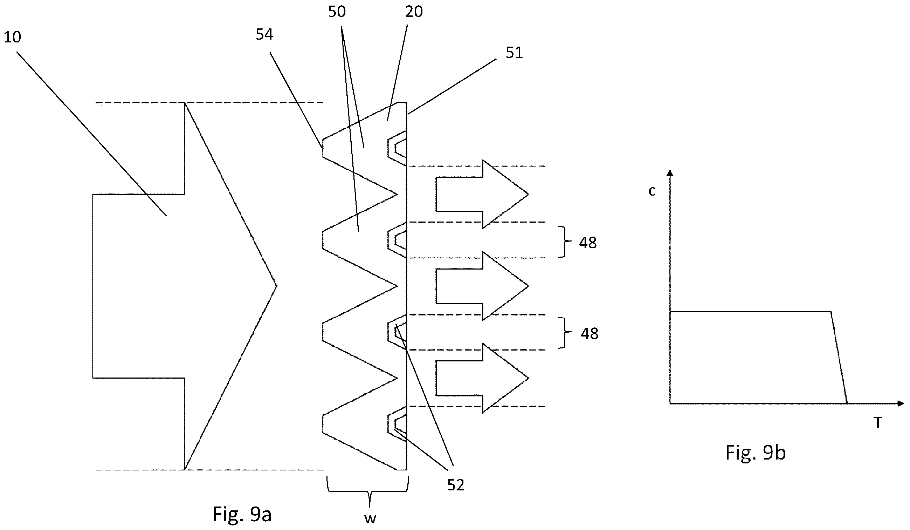

Die in Fig. 9a dargestellte Ausführungsform entspricht der Ausführungsform aus Fig. 8a mit dem Unterschied, dass die Mikrostrukturen 50 abgeflachte Spitzen 54 aufweisen. Wie im Dotierprofil des Substrats gemäß Fig. 9b zu erkennen ist, besteht kein Unterschied zum Dotierprofil des Substrats gemäß Fig. 8b. Lediglich der Verlauf der Implantationsbereiche 52 im Energiefilter 20 ist entsprechend der geänderten Form der Endbereiche um die Spitzen 54 der Mikrostrukturen 50 verändert, siehe Fig. 9a.

In allen Anwendungen kann der Energiefilter 20 auch schräg zur Strahlrichtung angeordnet sein derart, dass die gerade Fläche 51 des Energiefilters 20 unter einem spitzen Winkel zur Strahlrichtung angeordnet ist.

## Patentansprüche

1. Verfahren zur Ionenimplantation in ein Substrat (12), umfassend:
Implantieren von Dotieratomen in das Substrat (12) und/oder Erzeugen von Defektstellen im Substrat (12) mittels lonenimplantation unter Verwendung eines Energiefilters (20), wobei ein von einer lonenstrahlerzeugungsvorrichtung (11) erzeugter lonenstrahl (10) zunächst durch den Energiefilter (20) hindurchtritt und anschließend in das Substrat (12) gelangt,
wobei der Energiefilter (20) eine mikrostrukturierte Membran mit einem vordefinierten Strukturprofil zur Einstellung eines durch die Implantation hervorgerufenen Dotierstofftiefenprofils und/oder Defekttiefenprofils im Substrat (12) ist,
**dadurch gekennzeichnet, dass**
in einer Vielzahl von quer zur Strahlrichtung voneinander beabstandeten Bereichen (48) des Energiefilters (20), in denen der Energiefilter (20) einschließlich einer der Mikrostrukturen (50) in Strahlrichtung jeweils eine Ausdehnung (w) aufweist, die oberhalb einer vorbestimmten Grenze liegt, eine partielle Implantation von Fremdatomen mittels des lonenstrahls (10) durchgeführt wird und somit eine Vielzahl von voneinander beabstandeten, mit den Fremdatomen implantierten Implantationsbereichen (52) im Energiefilter (20) gebildet wird.

2. Verfahren nach Anspruch 1, **dadurch gekennzeichnet, dass** die Implantationsbereiche (52) im Energiefilter (20) periodisch angeordnet sind.

3. Verfahren nach Anspruch 1 oder 2, **dadurch gekennzeichnet, dass** eine Dicke der Implantationsbereiche (52) im Energiefilter (20) in Strahlrichtung mindestens 0,1 µm, bevorzugt mindestens 0,2 µm, beträgt.

4. Verfahren nach einem der vorangehenden Ansprüche, **dadurch gekennzeichnet, dass** eine Dicke der Implantationsbereiche (52) im Energiefilter (20) in Strahlrichtung von zwischen 0,1 µm und 2,0 µm, bevorzugt zwischen 0,15 µm und 1,5 µm beträgt.

5. Verfahren nach einem der vorangehenden Ansprüche, **dadurch gekennzeichnet, dass** eine Primärenergie des lonenstrahls (10) zwischen 1 MeV und 60 MeV, bevorzugt zwischen 2 MeV und 50 MeV, mehr bevorzugt zwischen 5 MeV und 40 MeV beträgt.

6. Verfahren nach einem der vorangehenden Ansprüche, **dadurch gekennzeichnet, dass** eine Dicke des Energiefilters (20) an den Stellen maximaler Erstreckung zwischen 3 µm und 60 µm, bevorzugt zwischen 5 µm und 50 µm, mehr bevorzugt zwischen 7 µm und 20 µm, beträgt.

7. Verfahren nach einem der vorangehenden Ansprüche, **dadurch gekennzeichnet, dass** eine Dicke der dotierten Schicht (21) im Substrat (12) zwischen 0,5 µm und 50 µm, bevorzugt zwischen 2 µm und 25 µm, mehr bevorzugt zwischen 3 µm und 20 µm beträgt.

8. Verfahren nach einem der vorangehenden Ansprüche, **dadurch gekennzeichnet, dass** die Mikrostrukturen (50) als zum Substrat (12) gewandte, abragende Mikrostrukturen (50) ausgebildet sind und die Implantationsbereiche (52) in den abragenden Mikrostrukturen (50) des Energiefilters (20) liegen.

9. Verfahren nach Anspruch 8, **dadurch gekennzeichnet, dass** sich die Implantationsbereiche (52) geradlinig erstrecken.

10. Verfahren nach einem der Ansprüche 1 bis 7, **dadurch gekennzeichnet, dass** die Mikrostrukturen (50) als vom Substrat (12) abgewandte, abragende Mikrostrukturen (50) ausgebildet sind und die Implantationsbereiche (52) abschnittsweise von einer geraden Fläche (51) des Energiefilters (20) aus verlaufen und abschnittsweise von der geraden Fläche (51) des Energiefilters (20) entfernt verlaufen.

11. Verfahren nach Anspruch 10, **dadurch gekennzeichnet, dass** die Implantationsbereiche (52) dreidimensionale Strukturen mit Ausdehnung in Dickenrichtung des Energiefilters (20) bilden.

12. Verfahren nach Anspruch 11, **dadurch gekennzeichnet, dass** die Implantationsbereiche (52) dreidimensionale Strukturen bilden, deren Form den Umrissen der Endbereiche um die Spitzen (54) der abragenden Mikrostrukturen (50) entspricht.

13. Verfahren nach einem der vorangehenden Ansprüche, **dadurch gekennzeichnet, dass** die abragenden Mikrostrukturen (50) als Vorsprünge ausgebildet sind.

14. Verfahren nach Anspruch 13, **dadurch gekennzeichnet, dass** die abragenden Mikrostrukturen (50) abgeflachte Spitzen (54) aufweisen.

15. Verfahren nach Anspruch 13 oder 14, **dadurch gekennzeichnet, dass** die abragenden Mikrostrukturen (50) eine Zackenform aufweisen.
